# EUROPEAN PATENT APPLICATION

(11) **EP 4 113 631 A1**
(43) Date of publication of application: **04.01.2023**
(21) Application number: 22181767.9
(22) Date of filing: 29.06.2022
(51) Int. Cl.: H01L 31/0392

(54) **METHOD FOR PRODUCING A PHOTOVOLTAIC MODULE TO BE APPLIED TO A SURFACE HAVING BIAXIAL CURVATURE**

(30) Priority: 01.07.2021 IT 202100017306
(71) Applicant: Solbian Energie Alternative S.r.l., 10051 Avigliana (Torino) (IT)
(72) Inventor: BONCI, Luca, I-55045 PIETRASANTA (Lucca) (IT); DI NATALE, Antonio, I-10153 TORINO (IT)
(74) Representative: Vanzini, Christian

(57) **Abstract**

Method for manufacturing a flexible photovoltaic panel (1) to be fixed to a double curvature support surface (R), said method comprising:
generating a numerical model of a flat structure (101) which is curved to conform to the support structure (R),
identifying, in the flat structure, compression zones (102, 103) which are subject to the formation of creases or lifting as a result of the curvature imposed by the support surface (R),
determining a pattern of photovoltaic cells to be arranged on the flat structure,
producing a flat photovoltaic panel (1) on the basis of the pattern of photovoltaic cells, and
forming cut-outs (104, 105) in the compression zones, the cut-outs being configured to close as a result of the curvature imposed by the support surface (R).

## Description

### FIELD OF THE INVENTION

This invention relates to photovoltaic modules and in particular to photovoltaic modules which may be applied to curved surfaces.

### BACKGROUND

Nowadays, the benefits of solar energy are well known. It is becoming more and more common to produce electrical energy by means of this clean, renewable, non-fossil source. In recent years, photovoltaic technology has become cheaper as a result of the increase in efficiency and the reduction in costs linked to the increase in production volumes, which has also been stimulated by government incentives. Meanwhile, the electrification of cars is proceeding at an increasingly fast rate. In this context, the use of solar energy for at least partially powering electric or hybrid cars is gaining attention. In order to apply a photovoltaic module to a car in a satisfactory manner, both in terms of functionality and aesthetics, it is necessary to consider that the surfaces of these cars almost always have a double curvature, i.e. a biaxial curvature. This problem, described herein using the automotive field of application as an example, is in fact a problem that is widespread: photovoltaic modules are usually produced by means of lamination, and are generally flat structures. The most common photovoltaic modules consist of a flat pane of glass and an aluminum frame, and are therefore intrinsically rigid; moreover, even flexible photovoltaic modules where a polymer replaces the glass may not be adapted to double curvature surfaces for topological reasons.

Though it is obviously possible to construct photovoltaic modules having a double curvature, using typical techniques for curving the glass or by means of injecting resins into molds, these are solutions that are more expensive than ordinary production of photovoltaic modules in flat laminating machines. These techniques have to be based on the creation of molds, and they are also limited in the freedom of varying the final result, since a new mold is required for every new surface to be covered with a photovoltaic module.

One example of a solar roof for passenger cars is the Ford C-Max Energi, presented in 2014, in which a support for the photovoltaic module is placed on the roof of the car, which support is designed to transform the double curvature of the roof into a single curvature. In so doing, flexible photovoltaic modules may be easily applied, but both the weight and the aerodynamics of the car are substantially modified. Examples where the roof of the car is instead replaced with a rigid photovoltaic module which is shaped to have a double curvature, for example, are proposed by the company a2Solar GmbH or installed by Toyota and Hyundai on some of their models. The latest announcement in this field comes from Japanese company Teijin Ltd, who have developed a curved roof using polycarbonate instead of glass. This is also a product produced by means of thermoforming, in suitable curved molds. Notably, all of the cases relate to products intended for original equipment, and are not to be applied to the roofs of cars that are already in circulation, i.e. in the aftermarket.

US4717790A describes how to produce a curved photovoltaic module starting from a glass surface which is already curved to the shape and size of the roof to be replaced. US20170141253A1 further improves this module by discussing how to reduce the stress of the connections between one cell and another, by arranging the cells in groups which follow one curvature or the other.

Methods which do not use glass or another pre-curved transparent material are described in EP3712964A1, in which the curvature of at least one of the two surfaces of the panel is obtained by a resin injection molding process, and NL2021711B1, which uses the idea of dividing the cells into groups so as to start with single lamination steps which take into consideration a single curvature and then combine everything in a final process which results in a surface having a biaxial curvature. These two methods are also based on the use of molds and lamination techniques that are slower and more complex than those used in the construction of standard photovoltaic modules, i.e. they are based on the use of flat vacuum laminating machines. This makes the process for producing said solar roofs more costly. Again, all of these techniques are suitable for producing original equipment solar roofs, and not for the market of vehicles that are already in circulation.

US20140130848A1 describes how a flexible photovoltaic module may be adapted to a double curvature surface if longitudinal cuts are made in the polymer material of the panel. In this way, the panel may partially deform in order to adapt to the convex double curvature of the roof. Disadvantages of this technique include the fact that the cuts follow the geometry of the cells and not the geometry of the roof, and therefore may not be effective for every possible curvature. Another disadvantage is that, by widening the cuts in order to allow deformation, the cells move away from each other, and the final result is therefore that of the cells on the surface of the roof having a density that is less than could be obtained by minimizing the spacing therebetween. Lastly, the process described finishes with the adhesion of the cut panel to a pre-curved, concave, transparent surface that forms the integral external surface of the roof. This again highlights the need to use different molds for each individual roof model.

The object of this invention is therefore that of providing a technique for producing flexible photovoltaic modules that may be adapted to surfaces having a biaxial curvature, but which technique is still based on conventional methods for producing photovoltaic modules in flat laminating machines.

### SUMMARY OF THE INVENTION

According to the invention, a method is provided for manufacturing a flexible photovoltaic panel to be fixed to a double curvature support surface, said method comprising:
generating a numerical model of a flat structure which is curved to conform to the support surface,
identifying, in said flat structure, compression zones which are subject to the formation of creases or lifting as a result of the curvature imposed by the support surface,
determining a pattern of photovoltaic cells to be arranged on said flat structure, said pattern comprising a plurality of blocks of photovoltaic cells which are separated from each other by said compression zones, wherein neighboring cells of a single block of cells have smaller mutual distances than neighboring cells separated by one of said compression zones,
producing a flat photovoltaic panel on the basis of said pattern of photovoltaic cells, wherein said photovoltaic panel comprises
   - a plurality of photovoltaic cells arranged according to said pattern of photovoltaic cells,
   - an encapsulating layer adapted to contain said photovoltaic cells therein,
   - at least one front layer which is made of flexible plastics material and is joined to and overlapping with said encapsulating layer on a first surface thereof, said front layer being exposed in use to sunlight, and
forming cut-outs in said compression zones, wherein said cut-outs pass through said encapsulating layer and front layer, said cut-outs being configured to close as a result of the curvature imposed by the support surface.

The invention is based on the observation that adapting a flat surface to a double curvature surface creates deformations of the first surface, with compression zones and dilation zones. Since the material with which a photovoltaic module is formed is not very deformable, it is in particular the compression zones which create problems, such as folds and lifting which prevent the photovoltaic module from adhering to the double curvature surface. This invention is therefore based on suitably shaping the profile of the photovoltaic module in order to alleviate or even eliminate the compression zones when the module/panel is applied to the double curvature surface. The photovoltaic module shaped in this manner folds onto this surface with little effort and covers this curved surface as completely as possible. Notably, this photovoltaic module may also be applied to existing surfaces, such as roofs of cars in circulation, and is therefore also designed as a product for the aftermarket.

A further object of the invention is a flexible photovoltaic panel to be fixed to a double curvature support surface, wherein said photovoltaic panel comprises
a plurality of photovoltaic cells arranged according to a pattern of photovoltaic cells, said pattern comprising a plurality of blocks of photovoltaic cells which are separated from each other by compression zones, wherein neighboring cells of a single block of cells have smaller mutual distances than neighboring cells separated by one of said compression zones,
an encapsulating layer adapted to contain said photovoltaic cells therein, said encapsulating layer being formed by a first layer and by a second layer which are arranged on opposite sides of said plurality of photovoltaic cells and fused around said photovoltaic cells,
at least one front layer which is made of flexible plastics material and is joined to and overlapping with said encapsulating layer on a first surface thereof, said front layer being exposed in use to sunlight, and
optionally at least one back layer which is made of flexible material and is joined to and overlapping with said encapsulating layer on a second surface thereof which is opposite said first surface,
wherein cut-outs that pass through said encapsulating layer, front layer and back layer are formed in said compression zones, said cut-outs being configured to close as a result of the curvature imposed by the support surface.

### DETAILED DESCRIPTION OF THE INVENTION

This invention will be better described by some preferred embodiments, which are provided by way of non-limiting example and with reference to the accompanying drawings, in which:
Fig. 1 is a schematic cross-sectional view of a portion of a photovoltaic panel according to the invention;
Fig. 2 is a schematic cross-sectional view of a variant of the photovoltaic panel in Fig. 1;
Fig. 3 is a block diagram which shows the main steps of a method for producing a photovoltaic panel according to the invention;
Fig. 4 shows a flat structure model intended to show the complete shape of a photovoltaic panel;
Fig. 5 shows the model of Fig. 4 to which an arrangement of photovoltaic cells is applied; and
Fig. 6 and 7 show a portion of the photovoltaic panel at a cut-out, respectively with the photovoltaic panel in a flat configuration and applied to a double curvature support surface.

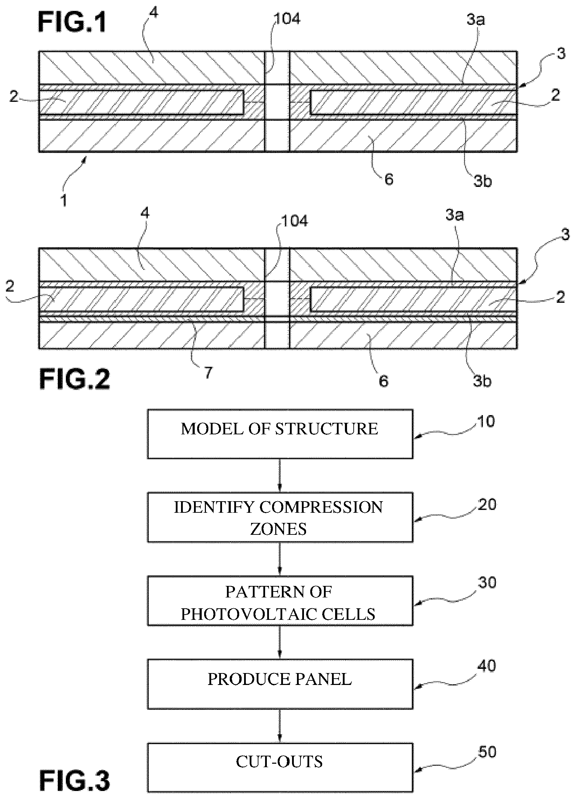

Fig. 1 shows a diagram of the layers that make up a flexible photovoltaic panel according to the invention. According to this diagram of layers, the flexible photovoltaic module, which is denoted as a whole by reference sign 1, essentially comprises
- a plurality of photovoltaic cells 2 which are arranged side by side, in particular the cells being made of mono- or poly-crystalline silicon. According to a preferred embodiment, the photovoltaic cells 2 are "back-contact" cells in which all of the electrical contacts (not shown) are formed on the back of the cell;
- at least one encapsulating layer 3 which is made of thermoplastic material and is adapted to contain the photovoltaic cells 2 therein, this encapsulating layer being formed by a first and by a second layer 3a, 3b which are arranged on opposite sides of the photovoltaic cells 2 and fused around said cells;
- at least one front layer 4 which is joined to and overlapping with the encapsulating layer 3 on a first surface thereof, this front layer 4 being exposed in use to sunlight, this at least one front layer 4 being made of flexible plastics material; and
- at least one back layer 6 which is made of flexible material and is joined to and overlapping with this encapsulating layer 3 on a second surface thereof that is opposite said first surface.

According to an embodiment which is not shown, the back layer 6 may be absent.

In this description, the terms "front" and "back" refer to the use condition of the photovoltaic panel. A "front" layer is oriented toward the sunlight, and is located between the light source and the encapsulating layer containing the photovoltaic cells. A "back" layer, however, is located on the opposite side of the encapsulating layer containing the cells.

This flexible photovoltaic module is produced according to conventional production techniques, i.e. by means of the following steps:
- selecting the photovoltaic cells on the basis of electrical parameters;
- welding the photovoltaic cells to each other, so as to form rows of electrically connected cells which are known as strings. This welding takes place using tinned copper metal parts, which ensure good electrical conductivity;
- assembling said strings in regular shapes, typically rectangles, in order to form a photovoltaic module having the desired dimensions, while simultaneously forming the electrical contacts through which the generated current is extracted from the finished module;
- overlapping the various layers according to the arrangement in Fig. 1;
- laminating in a flat vacuum laminating machine, in accordance with a temperature cycle that depends on the materials used.

Lamination requires a typical cycle time of 10-20 minutes, and is currently the most reliable, fast and economic process for producing photovoltaic modules based on poly- or monocrystalline silicon cells.

Fig. 2 shows a variant of the layering shown in Fig. 1, in which variant the back layer 6 comprises a conductive backsheet 7, i.e. a metal film which is contained inside the back layer(s) 6 and shaped so as to create an electrical circuit to which the photovoltaic cells 2 are connected. With the variant in Fig. 2, the production process does not include the creation of the strings of welded cells, since the single cells are directly connected to the conductive backsheet 7 which creates the complete electrical contact of the photovoltaic module. The other steps of the process described above remain the same. The variant in Fig. 2 makes it possible to more easily obtain freer arrangements of the photovoltaic cells, in which the linear geometry of the rows (strings) is replaced by a greater freedom of arrangement. The use of back-contact cells makes this easier to achieve.

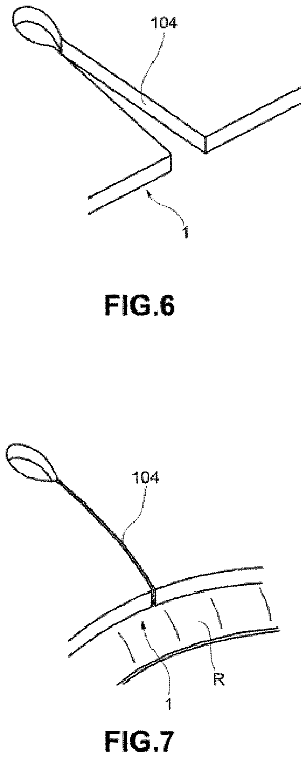

With reference to Fig. 3-7, a method will now be described for manufacturing the flexible photovoltaic panel 1 such that it may be fixed to a double curvature support surface such as the roof of a car, which support surface is denoted by reference sign R in Fig. 7. The support surface may be convex, as in the example shown. However, the invention also encompasses concave or saddle-shaped support surfaces. The photovoltaic panel 1 is made to adhere to the support surface R by means of the back layer 6 thereof or, if said back layer is absent, by means of the encapsulating layer 3.

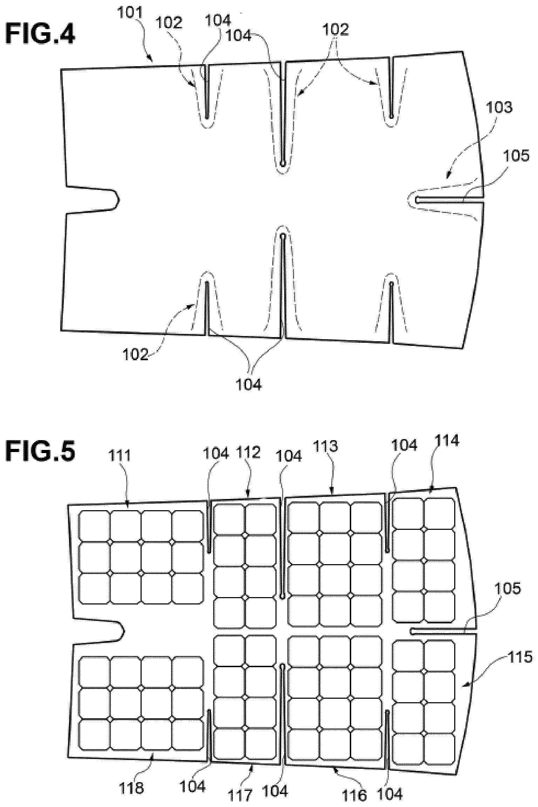

Firstly, a numerical model of a flat structure which is curved to conform to the support surface is generated (step 10 in Fig. 3). This modelled flat structure is shown schematically in Fig. 4 and denoted by reference sign 101.

Considering the double curvature surface R along which the photovoltaic module 1 is intended to be curved, it is necessary to study the deformations required to adapt the module 1 to the surface R. This may be done theoretically, using three-dimensional modelling systems such as the Rhinoceros^{®} software developed by Robert McNeel & Associates, which makes it possible to study the compression and expansion zones of a flat structure which is curved in order to adhere to a surface having a bidimensional curvature.

Then, in the modelled flat structure 101, compression zones are identified that are subject to the formation of creases or lifting as a result of the curvature imposed by the support surface R (step 20 in Fig. 3). These zones are shown approximately using dashed lines and denoted by reference signs 102 and 103 in Fig. 4. It is therefore possible to shape the edge of the photovoltaic module so as to remove the excess parts of the surface, i.e. those parts which, after curving, would form folds or other deformations, as will be described below.

A pattern of photovoltaic cells to be arranged on the flat structure 101 is then determined; this pattern comprises a plurality of blocks of photovoltaic cells (numbered 111 to 118 in Fig. 5) which are separated from each other by the compression zones 102, 103 determined in the preceding step, wherein neighboring cells of a single block of cells (for example in the single block 111 or 112) have smaller mutual distances than neighboring cells separated by one of the compression zones 102, 103 (for example neighboring cells of the block 111 and of the block 112 which are separated by the compression zone to the top left in Fig. 4 and 5, which compression zone is denoted by reference sign 102 in Fig. 4).

The photovoltaic panel is then produced according to the lamination process described above, with the photovoltaic cells 2 arranged on the basis of the pattern of photovoltaic cells determined in step 30 (step 40 in Fig. 3).

Cut-outs 104, 105 are then formed in the compression zones 102, 103 in order to remove the excess material as stated above (step 50 in Fig. 3). In so doing, it is possible to optimize the initial shape of the photovoltaic module by creating empty spaces (the cut-outs 104, 105; see also Fig. 6) which tend to close once the double curvature starts (see Fig. 7). This makes it possible to obtain the maximum coverage of the final surface R, even though starting from a flat photovoltaic module. In fact, the original photovoltaic module has a greater surface area than the curved surface to be covered. It is noted that the cut-outs 104, 105 are formed starting from the edge of the photovoltaic panel 1, and are oriented in mutually orthogonal directions.

The freedom to shape the edge of the photovoltaic module clearly depends on the presence or lack of cells which have the correct shape and are not able to be recut. To this end, it is necessary to start by finding a compromise between the arrangement of the cells and the requirements for shaping that depend on the particular curvature to be obtained. It is therefore understood how the described method for producing photovoltaic modules according to the variant in Fig. 2 may be more suitable for the purposes of this invention.

The photovoltaic panel 1 described above may be fixed to the support surface R in a manner known per se, for example using mechanical means or using adhesive materials, such that the back layer 6 or, if said back layer is absent, the encapsulating layer 3 adheres to the support surface R. According to one embodiment, the back layer 6 may comprise a magnetic material, in particular a permanent magnet, in order to facilitate the application of the photovoltaic panel 1 to a support surface R made of iron, or more generally a ferromagnetic support surface.

The advantage of this invention for the purposes of industrial production is clear. There is no longer any need to create molds for each type of surface, for the purpose of using hot-forming or injection-molding methods. The best shaping of the photovoltaic module may be studied numerically, and it is then possible to proceed to producing the photovoltaic module using the efficient, fast and economic method described above, in order to then shape the edges thereof simply by using a numerically-controlled cutter. Last but not least, this invention makes it possible to create photovoltaic modules that may be applied to cars that are already in circulation, by making the module adhere to the existing roof.

A further development is that of using the cut-outs 104, 105 to apply adhesive seals which have the function of sealing off the cuts from the upper side which is exposed to the hydrodynamic friction of the air, and at the same time may be used to mechanically fix the module to the roof of the car if intended for the aftermarket. These seals may be pre-formed so as to have the shape of the cut or may be created at the time using adhesive resins.

The application of the photovoltaic module may be facilitated by using vacuum techniques, i.e. by applying a vacuum bag above the module so as to compress it and make it adhere homogenously to the double curvature surface. In this process, heat may also be applied (for example by means of radiating lamps) such that, if thermosetting resins are used, the adhesion of the module to the surface is facilitated.

## Claims

1. A method for manufacturing a flexible photovoltaic panel (1) to be fixed to a double curvature support surface (R), said method comprising:
generating a numerical model of a flat structure (101) which is curved to conform to the support surface (R),
identifying, in said flat structure, compression zones (102, 103) which are subject to the formation of creases or lifting as a result of the curvature imposed by the support surface (R),
determining a pattern of photovoltaic cells to be arranged on said flat structure, said pattern comprising a plurality of blocks of photovoltaic cells (111-118) which are separated from each other by said compression zones (102, 103), wherein neighboring cells of a single block of cells have smaller mutual distances than neighboring cells separated by one of said compression zones,
producing a flat photovoltaic panel (1) on the basis of said pattern of photovoltaic cells, wherein said photovoltaic panel comprises
- a plurality of photovoltaic cells (2) arranged according to said pattern of photovoltaic cells,
- an encapsulating layer (3) adapted to contain said photovoltaic cells therein,
- at least one front layer (4) which is made of flexible plastics material and is joined to and overlapping with said encapsulating layer on a first surface thereof, said front layer being exposed in use to sunlight, and
forming cut-outs (104, 105) in said compression zones, wherein said cut-outs are configured to close as a result of the curvature imposed by the support surface (R).

2. The method according to claim 1, wherein said photovoltaic panel further comprises at least one back layer (6) which is made of flexible material and is joined to and overlapping with said encapsulating layer on a second surface thereof which is opposite said first surface, and wherein said cut-outs also pass through said at least one back layer.

3. A flexible photovoltaic panel to be fixed to a double curvature support surface (R), wherein said photovoltaic panel comprises
a plurality of photovoltaic cells (2) arranged according to a pattern of photovoltaic cells, said pattern comprising a plurality of blocks of photovoltaic cells (111-118) which are separated from each other by compression zones (102, 103), wherein neighboring cells of a single block of cells have smaller mutual distances than neighboring cells separated by one of said compression zones,
an encapsulating layer (3) adapted to contain said photovoltaic cells therein,
at least one front layer (4) which is made of flexible plastics material and is joined to and overlapping with said encapsulating layer on a first surface thereof, said front layer being exposed in use to sunlight,
wherein cut-outs (104, 105) passing through said encapsulating layer and front layer are formed in said compression zones, said cut-outs being configured to close as a result of the curvature imposed by the support surface (R).

4. The panel according to claim 3, further comprising at least one back layer (6) which is made of flexible material and is joined to and overlapping with said encapsulating layer on a second surface thereof which is opposite said first surface, wherein said cut-outs also pass through said back layer.

5. The panel according to claim 4, wherein said at least one back layer comprises a conductive backsheet (7).

6. The panel according to claim 4 or 5, wherein said at least one back layer comprises magnetic material.

7. The panel according to any of claims 3 to 6, wherein said photovoltaic cells have electrical contacts on a back side of the photovoltaic cells (2).

8. The panel according to any of claims 3 to 7, further comprising adhesive seals arranged in said cut-outs and configured to mechanically fix the photovoltaic panel to the support surface.
